(19) Europäisches Patentamt
European Patent Office
Office européen des brevets

(11) EP 3 098 971 B1

(12) EUROPEAN PATENT SPECIFICATION

(45) Date of publication and mention
of the grant of the patent:
**10.04.2019 Bulletin 2019/15**

(51) Int Cl.:
***H03M 13/11*** *(2006.01)*

(21) Application number: **14882555.7**

(86) International application number:
**PCT/CN2014/071992**

(22) Date of filing: **12.02.2014**

(87) International publication number:
**WO 2015/120584 (20.08.2015 Gazette 2015/33)**

(54) **METHOD AND APPARATUS FOR EFFICIENT CODING OF LDPC CODES**

METHODE UND VORRICHTUNG ZUR EFFIZIENTEN CODIERUNG VON LDPC CODES

APPAREIL ET PROCÉDÉ DE CODAGE EFFICACE DE CODES DE TYPE LDPC

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.11.2016 Bulletin 2016/48**

(73) Proprietor: **Huawei Technologies Co., Ltd.
Longgang District
Shenzhen, Guangdong 518129 (CN)**

(72) Inventor: **WANG, Kaiyao
Shenzhen
Guangdong 518129 (CN)**

(74) Representative: **Gill Jennings & Every LLP
The Broadgate Tower
20 Primrose Street
London EC2A 2ES (GB)**

(56) References cited:
CN-A- 101 399 553      CN-A- 101 588 183
CN-A- 101 699 770      CN-A- 102 158 232
US-A1- 2006 031 734    US-A1- 2009 070 652
US-A1- 2013 179 757

- **Gianluigi Liva et al.: "Design of LDPC codes: A survey and new results", Journal of Communincation Software and Systems, vol. 2 1 September 2006 (2006-09-01), pages 191-211, XP055056016, Retrieved from the Internet: URL:http://citeseerx.ist.psu.edu/viewdoc/d ownload?doi=10.1.1.125.2561&rep=rep1&type= pdf [retrieved on 2013-03-11]**
- **KIM J ET AL: "Quasi-Cyclic LDPC Codes for Fast Encoding", IEEE TRANSACTIONS ON INFORMATION THEORY, IEEE PRESS, USA, vol. 51, no. 8, 1 August 2005 (2005-08-01) , pages 2894-2901, XP011136337, ISSN: 0018-9448, DOI: 10.1109/TIT.2005.851753**
- **ECHARD R ET AL: "The PI-Rotation Low-Density Parity Check Codes", PROC., IEEE GLOBAL TELECOMMUNICATIONS CONFERENCE, GLOBECOM '01, SAN ANTONIO, TEXAS, USA, 25 - 29 NOVEMBER 2001, IEEE OPERATIONS CENTER, PISCATAWAY, NJ, 25 November 2001 (2001-11-25), pages 980-984, XP001099251, DOI: 10.1109/GLOCOM.2001.965564 ISBN: 978-0-7803-7206-1**

**EP 3 098 971 B1**

**Description**

**TECHNICAL FIELD**

The present invention relates to the communications field, and in particular, to a channel coding method and apparatus.

**BACKGROUND**

With development of communications technologies, channel coding has gradually become a relatively independent subject in the communications field and is widely applied to signaling transmission of an analog communications system and data transmission of a digital communications system, so as to improve transmission reliability and save a spectrum resource.

Low-density parity-check (LDPC) code is a type of channel coding scheme of excellent performance, and is intensively researched in recent years and widely applied to Digital Video Broadcasting-Satellite, deep space communications, and wireless communications.

Quasi-cyclic low-density parity-check (QC-LDPC) code is a type of special LDPC code. A check matrix of the quasi-cyclic low-density parity-check code includes multiple circulant submatrixes. However, in the prior art, because of a large calculation amount of a QC-LDPC coding scheme, coding complexity is relatively high, a coding time is long, and power consumption is relatively large.

**SUMMARY**

Embodiments of the present invention provide a channel coding method and apparatus, which can reduce coding complexity of LDPC code.

To achieve the foregoing objective, the following technical solutions are used in the embodiments of the present invention.

According to a first aspect, a channel coding method, applied to low-density parity-check LDPC coding, includes:

obtaining an information code vector M of LDPC code, where the information code vector M includes information that needs to be transmitted;

generating a check matrix of the LDPC code, where the check matrix is H=[H$_a$ H$_b$];

calculating P$^T$ according to a first formula $P^T = H_b^{-1} \cdot H_a \cdot M^T$, the information code vector M, and the check matrix H, and generating a check code vector P of the LDPC code according to P$^T$; and

generating a codeword vector of the LDPC code according to a second formula C=[M P], the information code vector M, and the check code vector P, where C is the codeword vector,

where

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k}$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

where $m$ and $n$ are positive integers, $k=n-m$, I is an $l$-order identity matrix, 0 is an $l$-order zero matrix, matrixes $A_1$ and $A_2$ are $l$-order submatrixes of the matrix $H_b$, in a binary matrix operation, $A_1+A_2=A$, A is an invertible matrix, $A_1$, $A_2$ and A are circulant matrixes, $E^{a_{ij}}$ is an $l$-order submatrix in the check matrix H, and $E^{a_{ij}}$ is a circulant identity matrix that is obtained by performing circular right shift on the $l$-order identity matrix by $a_{ij}$ bits, where $a_{ij} \in$ {-1,0,1,2,···,$l$-1},($1 \leq i \leq m, 1 \leq j \leq k$).

With reference to the first aspect, in the matrix $H_b$, $A = A_1 + A_2 = E^x$, ($1 \leq x \leq l$-1), where $E^x$ is a circulant identity matrix that is obtained by performing circular right shift on the $l$-order identity matrix by $x$ bits.

With reference to the first aspect, in a first possible implementation manner, before the calculating $P^T$ according to a first formula $P^T = H_b^{-1} \cdot H_a \cdot M^T$, the information code vector M, and the check matrix H, the method further includes:

equally dividing the information code vector M into $k$ segments by using $l$ bits as one segment, where M=[$M_1$ $M_2$ ... $M_k$];
equally dividing the check code vector P into $m$ segments by using $l$ bits as one segment, where it is assumed that P=[$P_1$ $P_2$ ... $P_m$];
recording the codeword vector C=[$M_1$ $M_2$ ... $M_k$ $P_1$ $P_2$ ... $P_m$]; and
substituting M=[$M_1$ $M_2$ ... $M_k$] and P=[$P_1$ $P_2$ ... $P_m$] into a third formula $H \cdot C^T$=0, to obtain the first formula $P^T = H_b^{-1} \cdot H_a \cdot M^T$.

According to a second aspect, a channel coding apparatus, applied to low-density parity-check LDPC coding, includes:

an obtaining unit, configured to obtain an information code vector M of LDPC code, where the information code vector M includes information that needs to be transmitted;
an operation unit, configured to generate a check matrix of the LDPC code, where the check matrix is H=[$H_a$ $H_b$], where the operation unit is further configured to: calculate $P^T$ according to a first formula $P^T = H_b^{-1} \cdot H_a \cdot M^T$, the infor-

mation code vector M that is obtained by the obtaining unit, and the check matrix H, and generate a check code vector P of the LDPC code according to $P^T$; and

a coding unit, configured to generate a codeword vector of the LDPC code according to a second formula C=[M P], the information code vector M that is obtained by the obtaining unit, and the check code vector P that is generated by the operation unit, where C is the codeword vector,

where

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

where $m$ and $n$ are positive integers, $k=n-m$, I is an $l$-order identity matrix, 0 is an $l$-order zero matrix, matrixes $A_1$ and $A_2$ are $l$-order submatrixes of the matrix $H_b$, in a binary matrix operation, $A_1 + A_2 = A$, A is an invertible matrix, $A_1$, $A_2$ and A are circulant matrixes, $E^{a_{ij}}$ is an $l$-order submatrix in the check matrix H, and $E^{a_{ij}}$ is a circulant identity matrix that is obtained by performing circular right shift on the $l$-order identity matrix by $a_{ij}$ bits, where $a_{ij} \in \{-1,0,1,2,\cdots,l-1\}$, $(1 \le i \le m, 1 \le j \le k)$.

With reference to the second aspect,
in the matrix $H_b$, $A = A_1 + A_2 = E^x$, $(1 \le x \le l-1)$, where $E^x$ is a circulant identity matrix that is obtained by performing circular right shift on the $l$-order identity matrix by x bits.

With reference to the second aspect, in a first possible implementation manner,

the operation unit is further configured to: equally divide the information code vector M into $k$ segments by using $l$

bits as one segment, where M=[M$_1$ M$_2$ ... M$_k$], and equally divide the check code vector P into $m$ segments by using $l$ bits as one segment, where it is assumed that P=[P$_1$ P$_2$ ... P$_m$]; and

the operation unit is further configured to: record the codeword vector C=[M$_1$ M$_2$ ... M$_k$ P$_1$ P$_2$ ... P$_m$], and substitute

M=[M$_1$ M$_2$ ... M$_k$] and P=[P$_1$ P$_2$ ... P$_m$] into a third formula $H \cdot C^T$ =0, to obtain the first formula $P^T = H_b^{-1} \cdot H_a \cdot M^T$.

With reference to the second aspect, in a second possible implementation manner, the apparatus comprises a processor, a memory, and a bus, and the processor and the memory are connected to each other by using the bus, wherein each of the obtaining unit, the operation unit, and the coding unit comprise the processor.

According to the channel coding method and apparatus that are provided in the embodiments of the present invention, an information code vector M of LDPC code is obtained; a check matrix H of the LDPC code is generated; P$^T$ is calculated according to a first formula, the information code vector M, and the check matrix H, and a check code vector P of the LDPC code is generated according to P$^T$; and a codeword vector C of the LDPC code is generated according to a second formula, the information code vector M, and the check code vector P, thereby reducing coding complexity of the LDPC code.

## BRIEF DESCRIPTION OF DRAWINGS

To describe the technical solutions in the embodiments of the present invention or in the prior art more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.

FIG. 1 is a schematic flowchart of a channel coding method according to an embodiment of the present invention;

FIG. 2 is a schematic diagram of a channel coding emulation curve according to an embodiment of the present invention;

FIG. 3 is a schematic structural diagram of a channel coding apparatus according to an embodiment of the present invention; and

FIG. 4 is a schematic structural diagram of a channel coding apparatus according to another embodiment of the present invention.

## DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

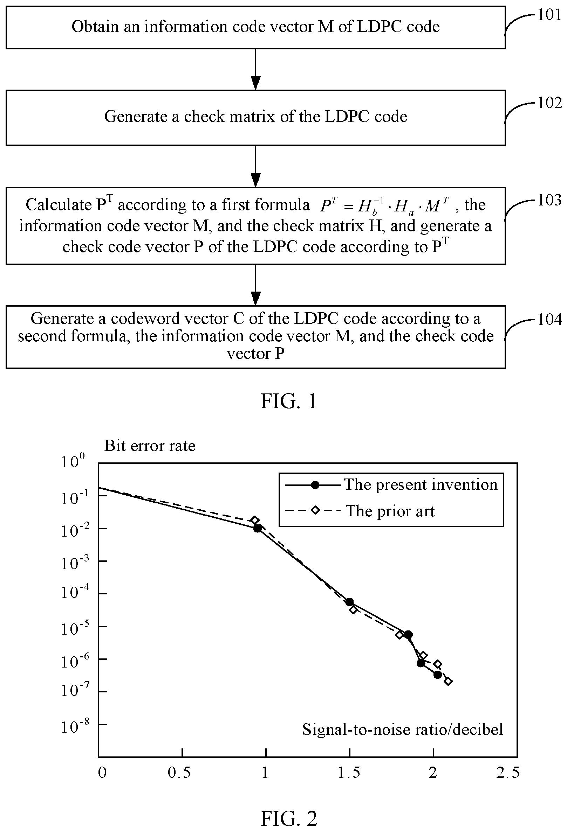

An embodiment of the present invention provides a channel coding method applied to LDPC coding. As shown in FIG. 1, the method includes the following steps:

101: Obtain an information code vector M of LDPC code.

The information code vector M includes information that needs to be transmitted. Specifically, optionally, the information code vector M is a binary digit sequence.

102: Generate a check matrix of the LDPC code, where the check matrix is H=[H$_a$ H$_b$].

Specifically,

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m}.$$

It may be obtained that a structure of the check matrix H is as follows:

$$H = \begin{bmatrix} E^{a_{11}} & E^{a_{12}} & \cdots & E^{a_{1k}} & A_1 & I & 0 & 0 & \cdots & 0 \\ E^{a_{21}} & E^{a_{22}} & \cdots & E^{a_{2k}} & 0 & I & I & 0 & \cdots & 0 \\ E^{a_{31}} & E^{a_{32}} & \cdots & E^{a_{3k}} & \vdots & \ddots & \ddots & \ddots & \ddots & \vdots \\ E^{a_{41}} & E^{a_{42}} & \cdots & E^{a_{4k}} & 0 & \cdots & 0 & I & I & 0 \\ \vdots & \vdots & \ddots & \vdots & 0 & 0 & \cdots & 0 & I & I \\ E^{a_{m1}} & E^{a_{m2}} & \cdots & E^{a_{mk}} & A_2 & 0 & \cdots & 0 & 0 & I \end{bmatrix}_{ml \times nl},$$

or

$$H = \begin{bmatrix} E^{a_{11}} & E^{a_{12}} & \cdots & E^{a_{1k}} & A_1 & 0 & 0 & \cdots & 0 & I \\ E^{a_{21}} & E^{a_{22}} & \cdots & E^{a_{2k}} & A_2 & I & 0 & \cdots & 0 & 0 \\ E^{a_{31}} & E^{a_{32}} & \cdots & E^{a_{3k}} & 0 & I & \ddots & \ddots & \vdots & \vdots \\ E^{a_{41}} & E^{a_{42}} & \cdots & E^{a_{4k}} & 0 & 0 & \ddots & I & 0 & 0 \\ \vdots & \vdots & \ddots & \vdots & \vdots & \vdots & \ddots & I & I & 0 \\ E^{a_{m1}} & E^{a_{m2}} & \cdots & E^{a_{mk}} & 0 & 0 & \cdots & 0 & I & I \end{bmatrix}_{ml \times nl}$$

where $m$ and $n$ are positive integers, $k=n-m$, I is an $l$-order identity matrix, 0 is an $l$-order zero matrix, and matrixes $A_1$ and $A_2$ are $l$-order submatrixes of the matrix $H_b$; in a binary matrix operation, $A_1+A_2=A$, A is an invertible matrix, and $A_1$, $A_2$ and A are circulant matrixes, that is, the matrixes $A_1$ and $A_2$ may be represented as $A_1 - a_0I+a_1E+a_2E^2+\cdots a_{l-1}E^{l-1}$, and $A_2=b_0I+b_1E+b_2E^2+\cdots b_{l-1}E^{l-1}$, where $a_s,b_s$ = (0,1),($0{\leq}s{\leq}l$-1), and $E^s$($0{\leq}s{\leq}l$-1) is a circulant identity matrix that is obtained by performing circular right shift on the $l$-order identity matrix by s bits; and $E^{a_{ij}}$ is an $l$-order submatrix in the check matrix H, and $E^{a_{ij}}$ is a circulant identity matrix that is obtained by performing circular right shift on the $l$-order identity matrix by $a_{ij}$ bits, where $a_{ij} \in \{-1,0,1,2,\cdots,l\text{-}1\},(1{\leq}i{\leq}m,1{\leq}j{\leq}k)$. Because the matrix $H_b$ has a special structure, the non-zero matrixes $A_1$ and $A_2$ satisfy that $A_1+A_2=A$, and A is an invertible circulant matrix, which reduces an operation amount in coding, and ensures performance of the LDPC code, thereby reducing coding complexity.

In the matrix $H_b$, $A = A_1+A_2 = E^x$, $(1{\leq}x{\leq}l\text{-}1)$, where $E^x$ is a circulant identity matrix that is obtained by performing circular right shift on the $l$-order identity matrix by $x$ bits. When the matrix A is a circulant identity matrix, the operation amount is further reduced, thereby further reducing the coding complexity of the LDPC code.

Further, optionally not forming part of the invention, in the matrix $H_b$, $A_1+A_2 = A = I$, where I is an $l$-order identity matrix.

Optimally but not forming part of the invention, when the matrix A is an identity matrix, performance of the LDPC code is ensured, and the coding complexity can be greatly reduced.

103: Calculate $P^T$ according to a first formula $P^T = H_b^{-1} \cdot H_a \cdot M^T$, the information code vector M, and the check matrix H, and generate a check code vector P of the LDPC code according to $P^T$.

104: Generate a codeword vector of the LDPC code according to a second formula C=[M P], the information code vector M, and the check code vector P, where C is the codeword vector.

Specifically, optionally, the second formula C=[M P] is substituted into a third formula $H \cdot C^T$ =0, to obtain the first formula $P^T = H_b^{-1} \cdot H_a \cdot M^T$, then the check code vector P is obtained through calculation according to the first formula, and further the codeword vector is generated by performing coding.

Because when a digital signal is transmitted, a bit error is often caused in a transferred data stream because of various reasons. Coding an information code vector to generate a codeword vector is actually adding a segment of data after original data. Data transmission efficiency may be improved by performing channel coding on the digital signal, so that a signal has error detection and error correction capabilities, thereby reducing a bit error rate and improving communication reliability. In the present invention, the digital signal is represented in a form of a single row vector. After coding is performed on the information code vector to generate the codeword vector, a channel coding process is completed. Specifically, optionally, the information code vector and the codeword vector are both binary digit sequences. The codeword vector may be sent to a receive end by means of baseband transmission or carrier transmission.

According to the channel coding method provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

Based on the embodiment corresponding to FIG. 1, an example not forming part of the present invention provides another channel coding method that is applied to LDPC coding. A specific solution is as follows:

obtaining an information code vector M of LDPC code, and generating a check matrix H of the LDPC code, where the information code vector M includes information that needs to be transmitted, and the check matrix H=[$H_a$ $H_b$]. Specifically,

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k}$$

$$H_b = \begin{bmatrix} E^i & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ 1+E^i & 0 & \cdots & 0 & 0 & I \end{bmatrix}_{m \times m},$$

or

$$H_b = \begin{bmatrix} E^i & 0 & 0 & \cdots & 0 & I \\ 1+E^i & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m}.$$

where $m$ and $n$ are positive integers, $k=n-m$, I is an $l$-order identity matrix, and 0 is an example not forming part of the invention $l$-order zero matrix. Corresponding to the corresponding to FIG. 1, herein, $A_1 = E^i$, $A_2 = I+E_j$, and $E^i$ ($0 \leq i \leq l-1$) is a circulant identity matrix that is obtained by performing circular right shift on the $l$-order identity matrix by $i$ bits; because in a binary matrix operation, a sum of same matrixes is 0, $A_1+A_2 = A = I$. $E^{aij}$ is an $l$-order submatrix in the check matrix H, and $E^{aij}$ is a circulant identity matrix that is obtained by performing circular right shift on the $l$-order identity matrix by $a_{ij}$ bits, where $a_{ij} \in \{-1,0,1,2,\cdots,l-1\}$, $(1 \leq i \leq m, 1 \leq j \leq k)$. Certainly, a structure of the matrix $H_b$ is not limited to this type. In this example not forming part of the invention, merely an example in which $A_1 = E^i$ and $A_2 = I + E^i$ is used for description.

It may be obtained that a structure of the check matrix H is as follows:

$$H = \begin{bmatrix} E^{a_{11}} & E^{a_{12}} & \cdots & E^{a_{1k}} & E^i & I & 0 & 0 & \cdots & 0 \\ E^{a_{21}} & E^{a_{22}} & \cdots & E^{a_{2k}} & 0 & I & I & 0 & \cdots & 0 \\ E^{a_{31}} & E^{a_{32}} & \cdots & E^{a_{3k}} & \vdots & \ddots & \ddots & \ddots & \ddots & \vdots \\ E^{a_{41}} & E^{a_{42}} & \cdots & E^{a_{4k}} & 0 & \cdots & 0 & I & I & 0 \\ \vdots & \vdots & \ddots & \vdots & 0 & 0 & \cdots & 0 & I & I \\ E^{a_{m1}} & E^{a_{m2}} & \cdots & E^{a_{mk}} & 1+E^i & 0 & \cdots & 0 & 0 & I \end{bmatrix}_{ml \times nl},$$

or

$$H = \begin{bmatrix} E^{a_{11}} & E^{a_{12}} & \cdots & E^{a_{1k}} & E^{i} & 0 & 0 & \cdots & 0 & I \\ E^{a_{21}} & E^{a_{22}} & \cdots & E^{a_{2k}} & 1+E^{i} & I & 0 & \cdots & 0 & 0 \\ E^{a_{31}} & E^{a_{32}} & \cdots & E^{a_{3k}} & 0 & I & \ddots & \ddots & \vdots & \vdots \\ E^{a_{41}} & E^{a_{42}} & \cdots & E^{a_{4k}} & 0 & 0 & \ddots & I & 0 & 0 \\ \vdots & \vdots & \ddots & \vdots & \vdots & \vdots & \ddots & I & I & 0 \\ E^{a_{m1}} & E^{a_{m2}} & \cdots & E^{a_{mk}} & 0 & 0 & \cdots & 0 & I & I \end{bmatrix}_{ml \times nl}$$

The information code vector M is equally divided into k segments by using $l$ bits as one segment, that is, M=[$M_1$ $M_2$ ... $M_k$]. The check code vector P is equally divided into $m$ segments by using $l$ bits as one segment. It is assumed that P=[$P_1$ $P_2$ ... $P_m$] and C=[M P], that is, C=[$M_1$ $M_2$ ... $M_k$ $P_1$ $P_2$ ... $P_m$] and C is a codeword vector of the LDPC code.

It can be known according to a channel coding principle that $H \cdot C^T = 0$. A first structure of the check matrix H is used as an example for description herein:

$$\begin{bmatrix} E^{a_{11}} & E^{a_{12}} & \cdots & E^{a_{1k}} & E^{i} & I & 0 & 0 & \cdots & 0 \\ E^{a_{21}} & E^{a_{22}} & \cdots & E^{a_{2k}} & 0 & I & I & 0 & \cdots & 0 \\ E^{a_{31}} & E^{a_{32}} & \cdots & E^{a_{3k}} & \vdots & \ddots & \ddots & \ddots & \ddots & \vdots \\ E^{a_{41}} & E^{a_{42}} & \cdots & E^{a_{4k}} & 0 & \cdots & 0 & I & I & 0 \\ \vdots & \vdots & \ddots & \vdots & 0 & 0 & \cdots & 0 & I & I \\ E^{a_{m1}} & E^{a_{m2}} & \cdots & E^{a_{mk}} & 1+E^{i} & 0 & \cdots & 0 & 0 & I \end{bmatrix} \bullet [M_1\ M_2 \ ...\ M_k\ P_1\ P_2\ ...\ P_m]^T = 0$$

It may be obtained that P=[$P_1$ $P_2$ ... $P_m$].

The LDPC code in this embodiment is compared with an emulation result of LDPC code in the prior art. Herein, for the LDPC code in the prior art, the Institute of Electrical and Electronics Engineers (IEEE) 802.11n protocol is used as an example for comparison. Operation amounts and operation times of the two types of code are shown in Table 1:

**Table 1**

| Code length (bit), Bit rate | Code type | Amount of multiplication calculation (times) | Amount of addition calculation (times) | Quantity of clock periods (pieces) |
|---|---|---|---|---|
| Code length 1944 Bit rate 1/2 | The present invention | 951345 | 953127 | 1075 |
| | The prior art | 1016955 | 1019547 | 1895 |
| Code length 648 Bit rate 1/2 | The present invention | 105705 | 106299 | 373 |
| | The prior art | 112995 | 113859 | 653 |
| Code length 1944 Bit rate 5/6 | The present invention | 531441 | 531927 | 1707 |
| | The prior art | 544563 | 545211 | 1871 |
| Code length 648 Bit rate 5/6 | The present invention | 59049 | 59211 | 573 |
| | The prior art | 60507 | 60723 | 629 |

The amount of multiplication calculation and the amount of addition calculation in Table 1 respectively represent a quantity of times of multiplication calculation and a quantity of times of addition calculation that need to be run in coding; the quantity of clock periods represents how many clock periods need to be spent in completing coding; the bit rate represents a ratio of information bits before coding to information bits after coding. It may be obtained according to Table 1 that an operation amount and an operation time that are of the LDPC code of the present invention are both less than those of LDPC coding in the prior art. Emulation curves of the two types of coding are shown in FIG. 2. FIG. 2 shows a situation in which bit error rates of two coding manners change as a signal-to-noise ratio changes. It may be found according to FIG. 2 that performance of the LDPC code (code length 1944 bits, bit rate 1/2) of the present invention and performance of the LDPC code (code length 1944 bits, bit rate 1/2) of the 802.11n protocol in the prior art are similarly very good. Therefore, on the premise of ensuring excellent LDPC performance, by means of the channel coding method of the present invention, a coding operation amount and a coding time that are of the LDPC code can be reduced, thereby reducing coding complexity of the LDPC code.

According to the channel coding method provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

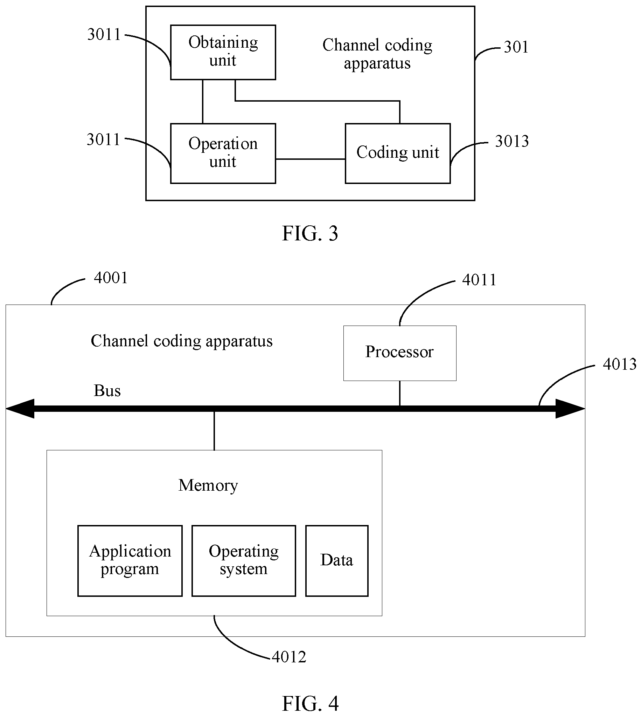

An embodiment of the present invention provides a channel coding apparatus, which is applied to LDPC coding. As shown in FIG. 3, the channel coding apparatus 301 includes: an obtaining unit 3011, an operation unit 3012, and a coding unit 3013. Specifically,

the obtaining unit 3011 is configured to obtain an information code vector M of LDPC code, where the information code vector M includes information that needs to be transmitted;
the operation unit 3012 is configured to generate a check matrix of the LDPC code, where the check matrix is H=[$H_a$ $H_b$], where

the operation unit 3012 is further configured to: calculate $P^T$ according to a first formula $P^T = H_b^{-1} \cdot H_a \cdot M^T$, the information code vector M that is obtained by the obtaining unit 3011, and the check matrix H, and generate a check code vector P of the LDPC code according to $P^T$; and
the coding unit 3013 is configured to generate a codeword vector of the LDPC code according to a second formula C=[M P], the information code vector M that is obtained by the obtaining unit 3011, and the check code vector P that is generated by the operation unit 3012, where C is the codeword vector,
where

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

where $m$ and $n$ are positive integers, $k=n-m$, $I$ is an $l$-order identity matrix, $0$ is an $l$-order zero matrix, matrixes $A_1$ and $A_2$ are $l$-order submatrixes of the matrix $H_b$, in a binary matrix operation, $A_1+A_2=A$, A is an invertible matrix, $A_1$, $A_2$ and A are circulant matrixes, $E^{a_{ij}}$ is an $l$-order submatrix in the check matrix H, and $E^{a_{ij}}$ is a circulant identity matrix that is obtained by performing circular right shift on the $l$-order identity matrix by $a_{ij}$ bits, where $a_{ij} \in \{-1,0,1,2,\cdots,l-1\}$, $(1 \leq i \leq m, 1 \leq j \leq k)$.

According to the channel coding apparatus provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

In the matrix $H_b$, $A = A_1 + A_2 = E^x$, $(1 \leq x \leq l-1)$, where $E^x$ is a circulant identity matrix that is obtained by performing circular right shift on the $l$-order identity matrix by $x$ bits.

Further, optionally, in an example not forming part of the invention in the matrix $H_b$, $A_1 + A_2 = A = I$, where I is an $l$-order identity matrix.

Optionally, the operation unit 3012 is further configured to: equally divide the information code vector M into $k$ segments by using $l$ bits as one segment, where $M=[M_1 \ M_2 \ ... \ M_k]$, and equally divide the check code vector P into $m$ segments by using $l$ bits as one segment, where it is assumed that $P=[P_1 \ P_2 \ ... \ P_m]$.

The operation unit 3012 is further configured to: record the codeword vector $C=[M_1 \ M_2 \ ... \ M_k \ P_1 \ P_2 \ ... \ P_m]$, and substitute $M=[M_1 \ M_2 \ ... \ M_k]$ and $P=[P_1 \ P_2 \ ... \ P_m]$ into a third formula $H \cdot C^T = 0$, to obtain the first formula

$$P^T = H_b^{-1} \cdot H_a \cdot M^T.$$

According to the channel coding apparatus provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

Another embodiment of the present invention provides a channel coding apparatus 4001. As shown in FIG. 4, the apparatus may be built in or may be a microcomputer, for example, a general-purpose computer, a customized computer, or a portable device such as a mobile phone terminal or a tablet computer. The channel coding apparatus 4001 includes: at least one processor 4011, a memory 4012, and a bus 4013. The at least one processor 4011 and the memory 4012 are connected to each other by using the bus 4013 and complete communication with each other.

The bus 4013 may be an industry standard architecture (ISA) bus, a peripheral component interconnect (PCI) bus, an extended industry standard architecture (EISA) bus, or the like. The bus 4013 may be classified into an address bus, a data bus, a control bus, and the like. For ease of illustration, the bus in FIG. 4 is represented by using only one bold line, but it does not mean that there is only one bus or one type of bus, where the memory 4012 is used for application program code for executing a solution in the present invention, where the application program code for executing the solution in the present invention is stored in the memory, and is controlled and executed by the processor 4011.

The memory may be a read-only memory ROM, a static storage device of another type that can store static information and an instruction, a random access memory RAM, or a dynamic storage device of another type that can store information and an instruction, or may be an electrically erasable programmable read-only memory EEPROM, a compact disc read-only memory CD-ROM or another optical disk storage, an optical disc storage (including a compact disc, a laser disc, an optical disc, a digital versatile disc, a Blu-ray disc, or the like), a magnetic disk storage medium or

EP 3 098 971 B1

another magnetic storage device, or any other medium that can be used to carry or store expected program code in an instruction or data structure form and that can be accessed by a computer, but the present invention is not limited thereto. These memories are connected to the processor by using the bus.

The processor 4011 may be a central processing unit (CPU) or an application specific integrated circuit (ASIC), or may be configured as one or more integrated circuits that implement the embodiments of the present invention.

The processor 4011 is configured to invoke the application program code in the memory 4012, in a possible implementation manner, to implement the following functions.

The processor 4011 is configured to obtain an information code vector M of LDPC code, where the information code vector M includes information that needs to be transmitted.

The processor 4011 is further configured to generate a check matrix of the LDPC code, where the check matrix is H=[$H_a$ $H_b$].

The processor 4011 is further configured to: calculate P$^T$ according to a first formula $P^T = H_b^{-1} \cdot H_a \cdot M^T$, the information code vector M, and the check matrix H, and generate a check code vector P of the LDPC code according to P$^T$.

The processor 4011 is further configured to generate a codeword vector of the LDPC code according to a second formula C=[M P], the information code vector M, and the check code vector P, where C is the codeword vector, where

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

where *m* and *n* are positive integers, *k=n-m,* I is an *l*-order identity matrix, 0 is an *l*-order zero matrix, matrixes A₁ and A₂ are *l*-order submatrixes of the matrix H*ᵦ*, in a binary matrix operation, A₁+A₂=A, A is an invertible matrix, A₁, A₂ and A are circulant matrixes, $E^{a_{ij}}$ is an *l*-order submatrix in the check matrix H, and $E^{a_{ij}}$ is a circulant identity matrix that is obtained by performing circular right shift on the *l*-order identity matrix by $a_{ij}$ bits, where $a_{ij} \in$ {-1,0,1,2,···,*l*-1}, (1≤*i*≤*m*,1≤*j*≤*k*).

According to the channel coding apparatus provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

In the matrix H*ᵦ*, $A = A_1 + A_2 = E^x$, (1≤*x*≤*l*-1), where $E^x$ is a circulant identity matrix that is obtained by performing circular right shift on the *l*-order identity matrix by *x* bits.

Optionally, in an example not forming part of the invention, in the matrix H*ᵦ*, $A_1 + A_2 = A = I$, where I is an *l*-order identity matrix.

Optionally, the processor 4011 is further configured to: equally divide the information code vector M into *k* segments by using *l* bits as one segment, where M=[M₁ M₂ ... M*ₖ*], and equally divide the check code vector P into *m* segments by using *l* bits as one segment, where it is assumed that P=[P₁ P₂ ... P*ₘ*].

The processor 4011 is further configured to: record the codeword vector C=[M₁ M₂ ... M*ₖ* P₁ P₂ ... P*ₘ*], and substitute M=[M₁ M₂ ... M*ₖ*] and P=[P₁ P₂ ... P*ₘ*] into a third formula $H \cdot C^T = 0$, to obtain the first formula

$$P^T = H_b^{-1} \cdot H_a \cdot M^T .$$

According to the channel coding apparatus provided in this embodiment, an information code vector M of LDPC code is obtained; a check matrix H of the LDPC code is generated; $P^T$ is calculated according to a first formula, the information code vector M, and the check matrix H, and a check code vector P of the LDPC code is generated according to $P^T$; and a codeword vector C of the LDPC code is generated according to a second formula, the information code vector M, and the check code vector P, thereby reducing coding complexity of the LDPC code.

With descriptions of the foregoing embodiments, a person skilled in the art may clearly understand that the present invention may be implemented by hardware, firmware or a combination thereof. When the present invention is implemented by software, the foregoing functions may be stored in a computer-readable medium or transmitted as one or more instructions or code in the computer-readable medium. The computer-readable medium includes a computer storage medium and a communications medium, where the communications medium includes any medium that enables a computer program to be transmitted from one place to another. The storage medium may be any available medium accessible to a computer. Examples of the computer-readable medium include but are not limited to: a random access memory (RAM), a read-only memory (ROM), an electrically erasable programmable read-only memory (EEPROM), a compact disc read-only memory (CD-ROM) or other optical disc storage, a disk storage medium or other disk storage, or any other medium that can be used to carry or store expected program code in an instruction or data structure form and can be accessed by a computer. In addition, any connection may be appropriately defined as a computer-readable medium. For example, if software is transmitted from a website, a server or another remote source by using a coaxial cable, an optical fiber/cable, a twisted pair, a digital subscriber line (DSL) or wireless technologies such as infrared ray, radio and microwave, the coaxial cable, optical fiber/cable, twisted pair, DSL or wireless technologies such as infrared ray, radio and microwave are included in fixation of a medium to which they belong. For example, a disk and a disc used by the present invention includes a compact disc (CD), a laser disc, an optical disc, a digital versatile disc (DVD disc), a floppy disk and a Blu-ray disc, where the disk generally copies data by a magnetic means, and the disc copies data optically by a laser means. The foregoing combination should also be included in the protection scope of the computer-readable medium.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A channel coding method, applied to low-density parity-check, LDPC, coding, comprising:

    obtaining an information code vector M of an LDPC code, wherein the information code vector M comprises information that needs to be transmitted;

generating a check matrix of the LDPC code, wherein the check matrix is H=[$H_a$ $H_b$];

calculating $P^T$ according to a first formula $P^T = H_b^{-1} \cdot H_a \cdot M^T$, the information code vector M, and the check matrix H, and generating a check code vector P of the LDPC code according to $P^T$; and

generating a codeword vector of the LDPC code according to a second formula C=[M P], the information code vector M, and the check code vector P, wherein C is the codeword vector, wherein

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k}.$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

wherein $m$ and $n$ are positive integers, $k=n-m$, I is an $l$-order identity matrix, 0 is an $l$-order zero matrix, matrixes $A_1$ and $A_2$ are $l$-order submatrixes of the matrix $H_b$, in a binary matrix operation, $A_1+A_2=A$, A is an invertible matrix, $A_1$, $A_2$ and A are circulant matrixes, $E^{a_{ij}}$ is an $l$-order submatrix in the check matrix H, and $E^{a_{ij}}$ is a circulant identity matrix that is obtained by performing circular right shift on the $l$-order identity matrix by $a_{ij}$ bits, wherein $a_{ij} \in \{-1,0,1,2,\cdots,l-1\}$, $1{\leq}i{\leq}m,1{\leq}j{\leq}k$; wherein, in the matrix $H_b$, $A = A_1 + A_2 = E^x$, $1{\leq}x{\leq}l-1$, wherein $E^x$ is a circulant identity matrix that is obtained by performing circular right shift on the $l$-order identity matrix by x bits.

**2.** The method according to claim 1, before the calculating $P^T$ according to a first formula $P^T = H_b^{-1} \cdot H_a \cdot M^T$, the information code vector M, and the check matrix H, further comprising:

equally dividing the information code vector M into $k$ segments by using $l$ bits as one segment, wherein M=[$M_1$

M$_2$ ... M$_k$];
equally dividing the check code vector P into $m$ segments by using $l$ bits as one segment, wherein it is assumed that P=[P$_1$ P$_2$ ... P$_m$];
recording the codeword vector C=[M$_1$ M$_2$ ... M$_k$ P$_1$ P$_2$ ... P$_m$]; and
substituting M=[M$_1$ M$_2$ ... M$_k$] and P=[P$_1$ P$_2$ ... P$_m$] into a third formula $H \cdot C^T = 0$, to obtain the first formula

$$P^T = H_b^{-1} \cdot H_a \cdot M^T .$$

3. A channel coding apparatus, applied to low-density parity-check, LDPC, coding, comprising:

an obtaining unit, configured to obtain an information code vector M of an LDPC code, wherein the information code vector M comprises information that needs to be transmitted;
an operation unit, configured to generate a check matrix of the LDPC code, wherein the check matrix is H=[H$_a$ H$_b$], wherein

the operation unit is further configured to: calculate P$^T$ according to a first formula $P^T = H_b^{-1} \cdot H_a \cdot M^T$, the

information code vector M that is obtained by the obtaining unit, and the check matrix H, and generate a check code vector P of the LDPC code according to P$^T$; and
a coding unit, configured to generate a codeword vector of the LDPC code according to a second formula C=[M P], the information code vector M that is obtained by the obtaining unit, and the check code vector P that is generated by the operation unit, wherein C is the codeword vector,
wherein

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k}$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m} ,$$

or

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

wherein *m* and *n* are positive integers, *k=n-m,* I is an *l*-order identity matrix, 0 is an *l*-order zero matrix, matrixes $A_1$ and $A_2$ are *l*-order submatrixes of the matrix $H_b$, in a binary matrix operation, $A_1+A_2=A$, A is an invertible matrix, $A_1$, $A_2$ and A are circulant matrixes, $E^{a_{ij}}$ is an *l*-order submatrix in the check matrix H, and $E^{a_{ij}}$ is a circulant identity matrix that is obtained by performing circular right shift on the *l*-order identity matrix by $a_{ij}$ bits, wherein $a_{ij} \in \{-1,0,1,2,\cdots,l\text{-}1\}$, $1{\leq}i{\leq}m,1{\leq}j{\leq}k$; wherein,
in the matrix $H_b$, $A = A_1 + A_2 = E^x$, $1{\leq}x{\leq}l\text{-}1$, wherein $E^x$ is a circulant identity matrix that is obtained by performing circular right shift on the *l*-order identity matrix by x bits.

4. The apparatus according to claim 3,
the operation unit is further configured to: equally divide the information code vector M into *k* segments by using *l* bits as one segment, wherein M=[$M_1$ $M_2$ ... $M_k$], and equally divide the check code vector P into *m* segments by using *l* bits as one segment, wherein it is assumed that P=[$P_1$ $P_2$ ... $P_m$]; and

the operation unit is further configured to: record the codeword vector C=[$M_1$ $M_2$ ... $M_k$ $P_1$ $P_2$ ... $P_m$], and substitute

M=[$M_1$ $M_2$ ... $M_k$] and P=[$P_1$ $P_2$ ... $P_m$] into a third formula H·$C^T$ =0, to obtain the first formula $P^T = H_b^{-1} \cdot H_a \cdot M^T$.

5. The apparatus of any of claim 3 or claim 4, wherein the apparatus comprises a processor, a memory, and a bus, and the processor and the memory are connected to each other by using the bus,
wherein each of the obtaining unit, the operation unit, and the coding unit comprise the processor.

**Patentansprüche**

1. Kanalcodierverfahren, angewendet auf eine Low-Density-Parity-Check-, LDPC-, Codierung, umfassend:

Erlangen eines Informationscodevektors M eines LDPC-Codes, wobei der Informationscodevektor M Informationen umfasst, die übertragen werden sollen;
Generieren einer Prüfmatrix des LDPC-Codes, wobei die Prüfmatrix H=[$H_a$ $H_b$] ist; Berechnen von $P^T$ gemäß einer ersten Formel $P^T = H_b^{-1} \cdot H_a \cdot M^T$ aus dem Informationscodevektor M und der Prüfmatrix H und Generieren eines Prüfcodevektors P des LDPC-Codes gemäß $P^T$, und
Generieren eines Codewortvektors des LDPC-Codes gemäß einer zweiten Formel C = [M P] aus dem Informationscodevektor M und dem Prüfcodevektor P, wobei C der Codewortvektor ist,

wobei

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

oder

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

wobei $m$ und $n$ positive Ganzzahlen sind, $k=n-m$, I eine Identitätsmatrix $l$-ter Ordnung ist, 0 eine Nullmatrix $l$-ter Ordnung ist, die Matrizen $A_1$ und $A_2$ Untermatrizen $l$-ter Ordnung der Matrix $H_b$ sind, in einer binären Matrixoperation, $A_1+A_2=A$, A eine invertierbare Matrix ist, $A_1$, $A_2$ und A zirkulante Matrizen sind, $E^{a_{ij}}$ eine Untermatrix $l$-ter Ordnung in der Prüfmatrix H ist und $E^{a_{ij}}$ eine zirkulante Identitätsmatrix ist, die durch Durchführen einer zirkulären Rechtsverschiebung an der Identitätsmatrix $l$-ter Ordnung um $a_{ij}$ Bits erhalten wird, wobei $a_{ij} \in \{-1,0,1,2,\cdots,l-1\}$, $1 \le i \le m$, $1 \le j \le k$; wobei, in der Matrix $H_b$, $A = A_1 + A_2 = E^x$, $1 \le x \le l-1$, wobei $E^x$ eine zirkulante Identitätsmatrix ist, die durch Durchführen einer zirkulären Rechtsverschiebung an der Identitätsmatrix $l$-ter Ordnung um x Bits erhalten wird.

**2.** Verfahren nach Anspruch 1, das, vor dem Berechnen von $P^T$ gemäß einer ersten Formel $P^T = H_b^{-1} \cdot H_a \cdot M^T$ aus dem Informationscodevektor M und der Prüfmatrix H, ferner umfasst:

gleichmäßiges Unterteilen des Informationscodevektors M in $k$ Segmente unter Verwendung von $l$ Bits als einem Segment, wobei M=[M$_1$ M$_2$ ... M$_k$];
gleichmäßiges Unterteilen des Prüfcodevektors P in $m$ Segmente unter Verwendung von $l$ Bits als einem Segment, wobei angenommen wird, dass P=[P$_1$ P$_2$ ... P$_m$];
Aufzeichnen des Codewortvektors C=[M$_1$ M$_2$ ... M$_k$ P$_1$ P$_2$ ... P$_m$]; und
Einsetzen von M=[M$_1$ M$_2$ ... M$_k$] und P=[P$_1$ P$_2$ ... P$_m$] in eine dritte Formel $H \cdot C^T = 0$, um die erste Formel $P^T = H_b^{-1} \cdot H_a \cdot M^T$ zu erhalten.

3. Kanalcodiervorrichtung, angewendet auf eine Low-Density-Parity-Check-, LDPC-, Codierung, umfassend:

eine Erlangungseinheit, eingerichtet zum Erlangen eines Informationscodevektors M eines LDPC-Codes, wobei der Informationscodevektor M Informationen umfasst, die übertragen werden sollen;

eine Betriebseinheit, eingerichtet zum Generieren einer Prüfmatrix des LDPC-Codes, wobei die Prüfmatrix $H=[H_a\ H_b]$ ist; wobei

die Betriebseinheit ferner eingerichtet ist zum: Berechnen von $P^T$ gemäß einer ersten Formel $P^T = H_b^{-1} \cdot H_a \cdot M^T$ aus dem Informationscodevektor M, der von der Erlangungseinheit erlangt wird, und der Prüfmatrix H und Generieren eines Prüfcodevektors P des LDPC-Codes gemäß $P^T$, und

eine Codiereinheit, eingerichtet zum Generieren eines Codewortvektors des LDPC-Codes gemäß einer zweiten Formel C = [M P] aus dem Informationscodevektor M, der von der Erlangungseinheit erlangt wird, und dem Prüfcodevektor P, der von der Betriebseinheit generiert wird, wobei C der Codewortvektor ist,

wobei

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

oder

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

wobei $m$ und $n$ positive Ganzzahlen sind, $k=n-m$, I eine Identitätsmatrix $l$-ter Ordnung ist, 0 eine Nullmatrix $l$-ter Ordnung ist, die Matrizen $A_1$ und $A_2$ Untermatrizen $l$-ter Ordnung der Matrix $H_b$ sind, in einer binären Matrixoperation, $A_1+A_2=A$, A eine invertierbare Matrix ist, $A_1$, $A_2$ und A zirkulante Matrizen sind, $E^{a_{ij}}$ eine Untermatrix $l$-ter Ordnung in der Prüfmatrix H ist und $E^{a_{ij}}$ eine zirkulante Identitätsmatrix ist, die durch Durchführen einer zirkulären Rechtsverschiebung an der Identitätsmatrix *l*-ter Ordnung um $a_{ij}$ Bits erhalten wird, wobei $a_{ij} \in \{-1,0,1,2,\cdots,l\text{-}1\}$, $1 \le i \le m$, $1 \le j \le k$ ; wobei, in der Matrix $H_b$, $A = A_1 + A_2 = E^x$, $1 \le x \le l\text{ - }1$, wobei $E^x$ eine zirkulante Identitätsmatrix ist, die durch Durchführen einer zirkulären Rechtsverschiebung an der Identitätsmatrix *l*-ter Ordnung um *x* Bits erhalten wird.

**4.** Vorrichtung nach Anspruch 3,
wobei die Betriebseinheit ferner eingerichtet ist zum: gleichmäßigen Unterteilen des Informationscodevektors M in *k* Segmente unter Verwendung von *l* Bits als einem Segment, wobei M=[$M_1 M_2 ... M_k$]; und gleichmäßigen Unterteilen des Prüfcodevektors P in *m* Segmente unter Verwendung von *l* Bits als einem Segment, wobei angenommen wird, dass P=[$P_1 P_2 ... P_m$], und
die Betriebseinheit ferner eingerichtet ist zum: Aufzeichnen des Codewortvektors C=[$M_1 M_2 ... M_k P_1 P_2... P_m$] ; und Einsetzen von M=[$M_1 M_2 ... M_k$] und P=[$P_1 P_2 ... P_m$] in eine dritte Formel $H \cdot C^T$=0, um die erste Formel $P^T = H_b^{-1} \cdot H_a \cdot M^T$ zu erhalten.

**5.** Vorrichtung nach einem von Anspruch 3 oder Anspruch 4, wobei die Vorrichtung einen Prozessor, einen Speicher und einen Bus umfasst und der Prozessor und der Speicher unter Verwendung des Busses miteinander verbunden sind,
wobei eine jeweilige der Erlangungseinheit, der Betriebseinheit und der Codiereinheit den Prozessor umfasst.

**Revendications**

**1.** Procédé de codage de canal, appliqué à un codage de contrôle de parité à faible densité, LDPC, comprenant :

l'obtention d'un vecteur M de code d'informations d'un code de type LDPC, dans lequel le vecteur M de code d'informations comprend des informations qui doivent être transmises ;
la génération d'une matrice de contrôle du code de type LDPC, dans lequel la matrice de contrôle est H=[$H_a H_b$] ;
le calcul de $P^T$ selon une première formule $P^T = H_b^{-1} \cdot H_a \cdot M^T$ , le vecteur M de code d'informations et la matrice H de contrôle, et la génération d'un vecteur P de code de contrôle du code de type LDPC en fonction de $P^T$ ; et
la génération d'un vecteur de mots codés du code de type LDPC selon une seconde formule C=[M P], le vecteur M de code d'informations et le vecteur P de code de contrôle, dans lequel C est le vecteur de mots codés, dans lequel

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k},$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

ou

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

dans lequel $m$ et $n$ sont des nombres entiers positifs, $k=n-m$, I est une matrice d'identité d'ordre $l$, 0 est une matrice nulle d'ordre $l$, les matrices $A_1$ et $A_2$ sont des sous-matrices d'ordre $l$ de la matrice $H_b$, dans une opération de matrice binaire, $A_1+A_2=A$, A est une matrice inversable, $A_1$, $A_2$ et A sont des matrices circulantes, $E^{a_{ij}}$ est une sous-matrice d'ordre $l$ dans la matrice H de contrôle, et $E^{a_{ij}}$ est une matrice d'identité circulante qui est obtenue en effectuant un décalage à droite circulaire sur la matrice d'identité d'ordre $l$ par $a_{ij}$ bits, dans lequel $a_{ij} \in \{-1, 0, 1, 2, ..., l-1\}$, $1 \le i \le m$, $1 \le j \le k$; dans lequel
dans la matrice $H_b$, A = $A_1$ + $A_2$ = $E^x$, $1 \le x \le l-1$,
dans lequel $E^x$ est une matrice d'identité circulante qui est obtenue en effectuant un décalage à droite circulaire sur la matrice d'identité d'ordre $l$ par $x$ bits.

2. Procédé selon la revendication 1, avant le calcul de $P^T$ selon une première formule $P^T = H_b^{-1} \cdot H_a \cdot M^T$, le vecteur M de code d'informations, et la matrice H de contrôle, comprenant en outre :

   la division de manière égale du vecteur M de code d'informations en $k$ segments en utilisant $l$ bits comme un segment, dans lequel M=[$M_1$ $M_2$... $M_k$] ;
   la division de manière égale du vecteur P de code de contrôle en $m$ segments en utilisant $l$ bits comme un segment, dans lequel on suppose que $\mathbb{P}=[P_1\ P_2\ldots\ P_m]$ ;
   l'enregistrement du vecteur de mots codés C=[$M_1$ $M_2$... $M_k$ $P_1$ $P_2$... $P_m$] ; et
   le remplacement de M=[$M_1$ $M_2$... $M_k$] et de P=[$P_1$ $P_2$... $P_m$] dans une troisième formule H•$C^T$=0, pour obtenir la première formule $P^T = H_b^{-1} \cdot H_a \cdot M^T$.

3. Appareil de codage de canal, appliqué à un codage de contrôle de parité à faible densité, LDPC, comprenant :

   une unité d'obtention, configurée pour obtenir un vecteur M de code d'informations d'un code de type LDPC, dans lequel le vecteur M de code d'informations comprend des informations qui doivent être transmises ;
   une unité de fonctionnement, configurée pour générer une matrice de contrôle du code de type LDPC, dans lequel la matrice de contrôle est H=[$H_a$ $H_b$], dans lequel l'unité de fonctionnement est configurée en outre pour :

   calculer $P^T$ selon une première formule $P^T = H_b^{-1} \cdot H_a \cdot M^T$, le vecteur M de code d'informations qui est obtenu par l'unité d'obtention, et la matrice H de contrôle, et générer un vecteur P de code de contrôle du code de type LDPC en fonction de $P^T$ ; et
   une unité de codage, configurée pour générer un vecteur de mots codés du code de type LDPC selon une seconde formule C=[M P], le vecteur M de code d'informations qui est obtenu par l'unité d'obtention, et le vecteur P de code de contrôle qui est généré par l'unité de fonctionnement, dans lequel C est le vecteur de mots codés,

   dans lequel

$$H_a = \begin{bmatrix} E^{a_{11}} & E^{a_{12}} & \cdots & E^{a_{1k}} \\ E^{a_{21}} & E^{a_{22}} & \cdots & E^{a_{2k}} \\ \vdots & \vdots & \ddots & \vdots \\ E^{a_{m1}} & E^{a_{m2}} & \cdots & E^{a_{mk}} \end{bmatrix}_{m \times k}.$$

$$H_b = \begin{bmatrix} A_1 & I & 0 & 0 & \cdots & 0 \\ 0 & I & I & 0 & \cdots & 0 \\ \vdots & \ddots & \ddots & \ddots & \ddots & \vdots \\ 0 & \cdots & 0 & I & I & 0 \\ 0 & 0 & \cdots & 0 & I & I \\ A_2 & 0 & \cdots & 0 & 0 & I \end{bmatrix}_{m \times m},$$

ou

$$H_b = \begin{bmatrix} A_1 & 0 & 0 & \cdots & 0 & I \\ A_2 & I & 0 & \cdots & 0 & 0 \\ 0 & I & \ddots & \ddots & \vdots & \vdots \\ 0 & 0 & \ddots & I & 0 & 0 \\ \vdots & \vdots & \ddots & I & I & 0 \\ 0 & 0 & \cdots & 0 & I & I \end{bmatrix}_{m \times m},$$

dans lequel $m$ et $n$ sont des nombres entiers positifs, $k=n-m$, I est une matrice d'identité d'ordre $l$, 0 est une matrice nulle d'ordre $l$, les matrices $A_1$ et $A_2$ sont des sous-matrices d'ordre $l$ de la matrice $H_b$, dans une opération de matrice binaire, $A_1+A_2=A$, A est une matrice inversable, $A_1$, $A_2$ et A sont des matrices circulantes, $E^{a_{ij}}$ est une sous-matrice d'ordre $l$ dans la matrice H de contrôle, et $E^{a_{ij}}$ est une matrice d'identité circulante qui est obtenue en effectuant un décalage à droite circulaire sur la matrice d'identité d'ordre $l$ par $a_{ij}$ bits, dans lequel $a_{ij} \in \{-1, 0, 1, 2, ..., l-1\}$, $1 \leq i \leq m$, $1 \leq j \leq k$; dans lequel

dans la matrice $H_b$, $A = A_1 + A_2 = E^x$, $1 \leq x \leq l-1$,

dans lequel $E^x$ est une matrice d'identité circulante qui est obtenue en effectuant un décalage à droite circulaire sur la matrice d'identité d'ordre $l$ par $x$ bits.

4. Appareil selon la revendication 3,
   l'unité de fonctionnement est configurée en outre pour : la division de manière égale du vecteur M de code d'informations en $k$ segments en utilisant $l$ bits comme un segment, dans lequel M=[M$_1$ M$_2$... M$_k$], et la division de manière égale du vecteur P de code de contrôle en $m$ segments en utilisant $l$ bits comme un segment, dans lequel on suppose que P=[P$_1$ P$_2$... P$_m$] ; et
   l'unité de fonctionnement est configurée en outre pour : l'enregistrement du vecteur de mots codés C=[M$_1$ M$_2$... M$_k$ P$_1$ P$_2$... P$_m$], et le remplacement de M=[M$_1$ M$_2$... M$_k$] et de P=[P$_1$ P$_2$... P$_m$] dans une troisième formule H•C$^T$=0, pour obtenir la première formule $P^T = H_b^{-1} \cdot H_a \cdot M^T$.

5. Appareil selon l'une quelconque de la revendication 3 ou de la revendication 4, dans lequel l'appareil comprend un processeur, une mémoire et un bus, et le processeur et la mémoire sont connectés l'un à l'autre à l'aide du bus, dans lequel chacune de l'unité d'obtention, de l'unité de fonctionnement et de l'unité de codage comprend le processeur.

| Obtain an information code vector M of LDPC code | 101 |

↓

| Generate a check matrix of the LDPC code | 102 |

↓

| Calculate $P^T$ according to a first formula $P^T = H_b^{-1} \cdot H_a \cdot M^T$, the information code vector M, and the check matrix H, and generate a check code vector P of the LDPC code according to $P^T$ | 103 |

↓

| Generate a codeword vector C of the LDPC code according to a second formula, the information code vector M, and the check code vector P | 104 |

FIG. 1

Bit error rate

FIG. 2

3011 — Obtaining unit

Channel coding apparatus

— 301

3011 — Operation unit

Coding unit — 3013

FIG. 3

— 4001

— 4011

Channel coding apparatus

Processor

— 4013

Bus

Memory

Application program

Operating system

Data

4012

FIG. 4